# EUROPEAN PATENT APPLICATION

(11) **EP 3 056 477 A1**
(43) Date of publication of application: **17.08.2016**
(21) Application number: 16155230.2
(22) Date of filing: 11.02.2016
(51) Int. Cl.: C04B 35/628, C23C 16/54

(54) **CONTINUOUS CHEMICAL VAPOR DEPOSITION/INFILTRATION COATER**

(30) Priority: 11.02.2015 US 201514619320
(71) Applicant: United Technologies Corporation, Farmington, CT 06032 (US)
(72) Inventor: KMETZ, Michael A., Colchester, CT Connecticut 06415 (US); NEWTON, Kirk C., Enfield, CT Connecticut 06082 (US)
(74) Representative: Iceton, Greg James

(57) **Abstract**

A method to form a ceramic interface coating on ceramic matrix composite (CMC) precursor tape 14 by a continuous process includes passing a ceramic fiber woven cloth tape or unidirectional tape of a first ceramic with a first and second surface through at least one reaction zone of a continuous vacuum chemical vapor deposition (CVD) or chemical vapor infiltration (CVI) reactor heated to a reaction temperature. The method further includes directing a flow of CVD or CVI reactant gas of a second ceramic at the first surface of the tape in a direction perpendicular to the tape such that the reactant gas passes through the tape in a forced flow process depositing the second ceramic on the fibers of the first ceramic thereby coating the fibers of the first ceramic tape with the second ceramic to interface coating form a coated fiber CMC precursor tape product.

## Description

### BACKGROUND

This invention relates to chemical vapor deposition, chemical vapor infiltration and ceramic matrix composite materials. In particular the invention relates to continuous production of interface coated ceramic matrix composite precursor fabrics and/or unidirectional tow sheets.

Ceramic matrix composite (CMC) materials are finding increased utility in gas turbine engines because of their high temperature applicability and low density. A common CMC structure consist of woven ceramic fibers in a sheet form such as a cloth infiltrated with the same or different ceramic to form a ceramic matrix composite with densities up to 100 percent. In most cases, the ceramic matrix is formed by either chemical vapor infiltration (CVI), polymer infiltration pyrolysis (PIP) or reactive melt infiltration (RMI). Regardless of matrix the mechanical integrity of all CMCs depends on a fiber interface coating to provide proper bonding/debonding behavior between the fiber and matrix that provides the toughening behavior that is required for successful application.

In general CVD is a process whereby a solid ceramic is deposited from the vapor phase, usually at an elevated temperature and reduced pressure. The high temperature provides the activation energy needed to make or break the precursor bonds of a reactant gas. Low pressure provides for a more efficient method to defuse the reactive and byproduct gases to and from the substrate. The deposition rate is directly proportional to the precursor gas concentration, partial pressure and temperature. CVI is a process whereby a pore filling solid is deposited from a reactant gas vapor phase. This process is similar to CVD in that it uses both elevated temperatures and low pressures, but the temperatures and pressures are generally lower to reduce the deposition rate and provide the required increased time for reactant gases to defuse into a porous substrate before reacting. The lower pressure allows for a greater "mean free path" for the reactant vapors to travel before contacting a nucleation cite and reacting.

Increased throughput in CVD or CVI processing is a continuing goal in the art.

### SUMMARY

A method to form a ceramic interface coating on ceramic matrix composite (CMC) precursor tape by a continuous process includes passing a ceramic fiber woven cloth tape or unidirectional tape of a first ceramic with a first and second surface through at least one zone of a continuous vacuum chemical vapor deposition (CVD) or chemical vapor infiltration (CVI) reactor heated to a reaction temperature. The method further includes directing a flow of CVD OR CVI reactant gas of a second ceramic at the first surface of the tape in a direction perpendicular to the tape such that the reactant gas passes through the tape in a forced flow process depositing the second ceramic on the fibers of the first ceramic thereby coating the fibers of the first ceramic tape with the second ceramic to form a coated fiber CMC precursor tape product.

An apparatus to continuously form ceramic interface coatings on ceramic matrix composite (CMC) precursor tape includes a ceramic fiber woven cloth tape or unidirectional tape of a first ceramic with a first and second surface mounted on a supply spool in a storage chamber. The storage chamber also contains a tension roller, a purge gas inlet and a tape outlet seal. The apparatus further includes at least one chemical vapor deposition (CVD) or chemical vapor infiltration (CVI) deposition zone. The deposition zone consists of a vacuum chamber, containing a tape inlet seal, a reactive gas dispensing system directed at the first side of the tape in a direction perpendicular to the tape for forming a CVD or CVI coating of a second ceramic on the fibers to form an interface coating, a purge gas inlet, at least one heating element for heating the tape to a CVD or CVI reaction temperature, a vacuum system, high temperature insulation, and a tape outlet seal. The apparatus further includes a collection chamber containing a tape collection spool mounted on a drive shaft, a tension roller, a purge gas inlet and a tape inlet seal. The apparatus also includes a variable speed drive attached to the collection spool to gather the coated CMC precursor tape product on the collection spool.

### BRIEF DESCRIPTION OF THE DRAWINGS

FIG. 1 is a schematic representation of a forced flow isothermal continuous CVI reactor of the invention.
FIG. 2 is a schematic representation of a forced flow thermal gradient continuous CVI reactor of the invention.

### DETAILED DESCRIPTION

This disclosure describes the development of a continuous coater to be used to form interface coatings on CMC precursor woven porous fiber cloth or unidirectional tape. As discussed above, a CMC may be a woven ceramic fiber cloth or unidirectional tape that is infiltrated with a matrix by any suitable infiltration process including CVI, PIP, RMI and others known in the art of the same or different ceramic such that the surfaces of the fibers are coated with a matrix bond enhancing interface. As known in the art, the bond strength between the fibers and the matrix may be optimized with an interface coating to maximize the mechanical properties of the composite matrix composite material. The density of the CMC may approach 100 percent depending on the application.

CVD is a process whereby a solid is deposited from the vapor phase, usually at elevated temperatures and low pressures. The high temperature provides the activation energy needed to make or break the precursor bonds in a reactant gas. The low pressure provides for an efficient method to defuse the reactant and byproduct gases to and from the substrate. The deposition rate is directly proportional to the precursor gas concentration, partial pressure and temperature.

CVI is a process whereby a pore filing solid is deposited from a vapor phase. The process is similar to CVD in that it uses both elevated temperatures and low pressures but the temperatures and pressures are generally lower to reduce the deposition rate and provide greater time for precursor reactant gases to defuse into the porous substrate before reacting. The lower pressure allows for a greater "mean free path" for the precursor vapors to travel before impacting a nucleation cite and reacting. If a CVI process is run like a CVD process, i.e. with a high deposition rate induced by high temperatures and/or high precursor partial pressure, the deposition rate through the thickness of the sample will vary greatly, with the deposition rate at the surface being much higher than the deposition rate inside the substrate. Carefully controlling deposition parameters allows deposition rates within the substrate to be equal to or higher than deposition rates at the surface in order to allow even deposition throughout the entire substrate.

There are several CVI processes that attempt to accomplish the effect of controlling the deposition rate throughout the thickness of a woven fiber substrate. Exemplary processes include isothermal/isobaric, forced flow/isothermal, and forced flow/thermal gradient procedures. By far the most common process is isothermal/isobaric. In an isothermal/isobaric CVI process, the substrates that are intended to be infiltrated are loaded into a reactor in which the pressure and temperature are held constant throughout the volume of the reactor and the reactor is allowed to run for an extended period of time. Deposition (or infiltration) is governed by the diffusion of reactant gases into the substrate and the diffusion of byproduct effluent gases out of the substrate. The distribution of precursor reactant gases through the volume of the reactor is controlled to maintain a constant deposition rate throughout the reactor from location to location. Deposition rates throughout the volume of a given sample are dictated by reactant partial pressures and are higher at the surface than at internal locations. Minimizing this deposition rate gradient demands that the process be run at very low pressures and low deposition rates. The process is extremely slow but very simplistic.

A forced flow/isothermal CVI process eliminates diffusion control by forcing precursor reactants to fill a woven fiber preform and decompose or react to form the desired product. This forced flow is accomplished by creating a pressure differential across the substrate with the precursor reactant gas supplied at a higher pressure on the supply side than on the vacuum exhaust side. The forced flow process ensures a high concentration of precursor reactant gas through the porosity of the substrate thereby increasing the reaction rate through the entire thickness of a woven fiber substrate. This increases infiltration rate by up to several orders of magnitude. The forced flow/isothermal process is typically used for thin cross-section materials where the reduction in precursor concentration through the thickness due to reaction is minimal and the reaction rate through the bulk of the sample constant or nearly constant.

A forced flow thermal gradient process is a CVI process that combines forced flow with an engineered thermal gradient through the thickness of the substrate being infiltrated. The thermal gradient is set up such that the reactant gas precursor feed side of the substrate is at a lower temperature than the exhaust side. In this arrangement, the thermal gradient offsets the reduction in deposition rate through the thickness of the substrate due to reactant depletion and results in a constant deposition rate through the thickness of the substrate. On the precursor feed side, the reactant concentration is high, but the temperature is low. On the vacuum exhaust side of the substrate, the reactant concentration is low due to depletion, but the temperature is high encouraging diffusion. By controlling the thermal gradient through the thickness of the substrate, it is possible to optimize a forced flow thermal gradient CVI process to achieve constant or nearly constant deposition rate through the entire thickness of the sample. This process is typically used for thick cross-section infiltrations that would be difficult or impossible to perform with isothermal/isobaric or forced flow isothermal CVI processes.

The deposition of an interface coating onto the fibers of a woven fabric substrate or a unidirectional tape requires a process that is fundamentally more of a CVI process than a CVD process. In order to apply an even thickness, thin multi-layered coating onto each individual filament within the tows of fiber that make up a fabric or unidirectional tape, a process that is analogous to the infiltration of pores within a porous substrate may be performed. The precursors must diffuse around all sides of all the filaments and react at approximately the same rate to achieve an even coating thickness distribution throughout the fabric.

In the present disclosure, methods and apparatus to continuously produce interface coating ceramic fabric and unidirectional tape by two processes are described.

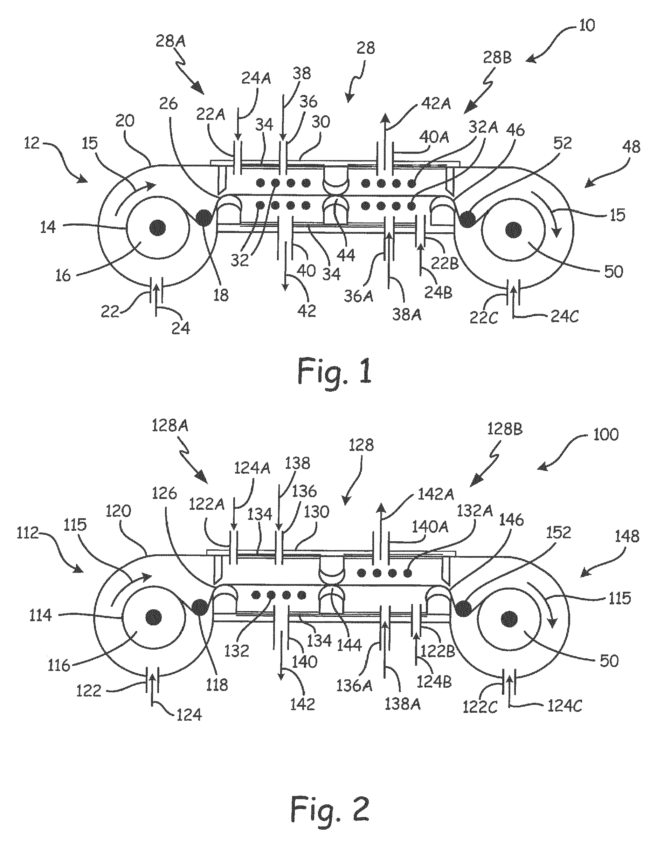

In one embodiment of the invention, interface coated fabric may be continuously produced by forced flow isothermal chemical vapor infiltration (CVI). Forced flow isothermal continuous CVI reactor 10 of the invention is shown in FIG. 1. In reactor 10, the starting material may be woven ceramic fiber tape, or fabric cloth or parallel ceramic fiber tape. Unfilled precursor ceramic tape 14 in continuous CVI reactor 10 is housed in metal storage chamber 12 on spool 16. The width of tape 14 may be from 6 inches (15.24 cm) to 60 inches (152.4 cm) and the thickness may be from 0.006 inches (152 microns) to 0.25 inches (6350 microns). During processing, tape 14 in storage chamber 12 travels from left to right as indicated by arrow 15 under tension roller 18 into deposition chamber 28 through tape exit seal 26. Tape storage chamber 12 is maintained under a controlled positive pressure atmosphere by purge gas entering chamber 12 through purge gas inlet 22 as indicated by arrow 24. In the embodiment shown, deposition chamber 28 has two insulated deposition zones 28A and 28B. Insulated deposition zones 28A and 28B are contained in metal shell 30 lined with thermal insulation 34. After tape 14 passes over tension roller 18, it passes into metal deposition zone 28A through storage chamber tape outlet seal 26.

In the exemplary embodiment shown in FIG. 1, reactor 10 has two deposition zones. In other embodiments, reactor 10 may have any number of deposition zones, depending on the nature and requirements of the deposited interface layer or layers. Formation of multilayer interface coatings of the invention may be carried out with multiple deposition zones or with multiple passes through a single deposition zone. Each deposition zone may be configured to deposit the same chemistry in a given fabric pass or each zone may deposit a different coating chemistry in a given fabric pass.

Deposition zone 28A is protected with purge gas 24A entering deposition zone 28A through purge gas inlet 22A as indicated by arrow 24A. Tape 14 is heated by resistance heating elements 32 positioned on both sides of tape 14 in deposition zone 28A. Heating elements 32 may be resistance heated graphite rods or plates.

Reactant gas 28 enters reaction zone 28A through gas inlet 36 as indicated by arrow 38. In the embodiment shown, reactant gas 38 is directed at tape 14 in a direction perpendicular to the surface of tape 14 to ensure maximum penetration of reactant gas 38 into tape 14. Reaction zone 28A is evacuated through vacuum outlet 40 as indicated by arrow 42. Outlet 40 is connected to a vacuum system, traps and vacuum controls (not shown.) The vacuum system removes unreacted reactant gas and reacted gaseous effluents from reaction zone 28A during a run.

Heating elements 32 positioned on both sides of tape 14 in reaction zone 28A provide an isothermal coating environment for tape 14 as it travels under reactant gas inlet 36 dispensing reactant gas 38 in a direction perpendicular to the surface of tape 14. Vacuum 42 creates a pressure differential in reaction zone 38A that pulls reactant gas 38 through tape 14 enhancing penetration of reactant gas 38 into tape 14.

After tape 14 passes through reaction zone 28A, it exits the reaction zone through tape outlet seal 44 and enters reaction zone 28B. Reaction zone 28B is identical to reaction zone 28A except that the direction of reactant gas flow 38A in gas inlet 36A is directed at the bottom of tape 14 in vacuum outlet 40A for the purpose of improving coating homogeneity through the thickness of tape 14. Vacuum outlet 40A is connected to vacuum system 42A and evacuates the top side of tape 14. In this zone the flow of reactant gas 38A is directed at the bottom of tape 24 in a direction perpendicular to tape 14. Resistance heaters 32A maintain an isothermal temperature in reaction zone 28B and the vacuum system indicated by arrow 42A in outlet 40A creates a pressure differential in reaction zone 28B that draws reactant gas 38A into the bottom side of tape 14 and evacuates unreacted reactant gas 38A and reacted gas effluent from the top surface of tape 14 from reaction chamber 28B. In this way, fibers at the bottom side of tape 14 that were not completely coated in reaction zone 28A may be further coated to increase the homogeneity of the interface coating on the fibers of CMC precursor porous tape 14 of the invention.

Infiltrated, coated ceramic fiber tape 14 exits reaction zone 28 and enters metal collection chamber 48 through tape inlet seal 46. Collection chamber 48 is maintained under a controlled atmosphere by purge gas 24C entering purge gas inlet 22C. Coated ceramic fiber tape 14 passes under tension roller 52 and is wound on collection spool 50 in the direction indicated by arrow 15. By passing coated fiber tape 14 under tension roller 52, the deformation imparted to the tape will tend to separate filtration fiber contact points (i.e. "bridges") and increase the flexibility of coated fiber tape 14. Collection spool 50 is driven by a variable speed drive (not shown) to gather infiltrated ceramic fiber tape 14 for further processing.

In another embodiment of the invention, CMC precursor interface coated fabric or unidirectional tape is continuously produced by forced flow thermal gradient chemical vapor infiltration (CVI). Forced flow thermal gradient continuous CVI reactor 100 is shown in FIG. 2. The starting material for the fiber coating process may be parallel ceramic fiber tape, fabric or cloth woven ceramic fiber tape. Ceramic fiber tape 114 in continuous CVI reactor 100 is housed in metal storage chamber 112 on spool 116. The width of tape 114 may be from 6 inches (15.24 cm) to 60 inches (125.4cm) and the thickness may be from 0.006 inches (152 microns) to 0.25 inches (6350microns). During processing, ceramic fiber tape 114 in storage chamber 112 travels from left to right as indicated by arrow 115 under tension roller 118 into deposition chamber 128 through tape exit seal 118. Tape storage chamber 112 is maintained under a controlled positive pressure atmosphere by purge gas entering chamber 112 through purge gas inlet 122 as indicated by arrow 124. The embodiment showing metal deposition chamber 128 has two insulated deposition zones, 128A and 128B. Insulated deposition zones 128A and 128B are contained in metal shell 130 lined with thermal insulation 134. After tape 114 passes under tension roller 118, it passes into metal deposition zone 128A through storage chamber tape outlet seal 126.

Deposition zone 128A is protected with purge gas 124A entering deposition zone 128A through purge gas inlet 122A as indicated by arrow 124A. In the embodiment shown, the bottom of tape 114 is heated by resistance heating elements 132 positioned under tape 114 to form a temperature gradient across tape 114.

Reactant gas enters reaction zone 128A through gas inlet 136 as indicated by arrow 138. In the embodiment of the invention, reactant gas 138 is directed at tape 114 in a direction perpendicular to the surface of tape 114 to ensure penetration of reactant gas 138 into tape 114. In the absence of heating elements above tape 14, the top side of tape 14 is at a lower temperature than the bottom side and the rate of formation of reaction product at the top side of tape 114 is low. However, since the bottom of the tape is at a higher temperature than the top side, the reaction product in that region is formed at a higher rate whereby the deposition rate of coating infiltrant in the lower half of the tape balances that forming in the reactant gas feed side and a constant deposition rate may be achieved throughout the thickness of the tape. Reaction zone 128A is evacuated through vacuum outlet 140 as indicated by arrow 142. Outlet 140 is connected to a vacuum system, traps and vacuum controls not shown. The vacuum system provides a pressure differential that assists in drawing reactant gas 138 through the thickness of tape 114 during the CVI process. The vacuum system removes unreacted reactant gas and reacted gaseous effluents from reaction zone 128A during a run.

In the exemplary embodiment shown in FIG.2, reactor 110 has two deposition zones. In other embodiments, reactor 110 may have any number of deposition zones, depending on the nature and requirements of the deposited interface layer or layers. Formation of multilayer interface coatings of the invention may be carried out with multiple deposition zones or with multiple passes through a single deposition zone. Each deposition zone may be configured to deposit the same chemistry in a given fabric pass or each zone may deposit a different chemistry in a given fabric pass

After tape 114 passes through reaction zone 128A, it exits the reaction zone through tape outlet seal 144 and enters reaction zone 128B. Reaction zone 128B is identical to reaction zone 128A except that the direction of reactant gas flow 138A from gas flow inlet 136A is opposite to that in reaction zone 128A for the purpose of improving coating homogeneity through the thickness of tape 114. In addition, heating elements 132A are positioned to heat only the top side of tape 124 opposite the reactant gas inlet side and to create a temperature gradient in reaction zone 128B. Vacuum system 142A is also on the heated side in reaction zone 128B and creates a pressure differential that draws reactant gas 138A into the bottom of tape 114 and evacuates unreacted reactant gas 138A and reacted gas effluent from the top side of tape 114 in reaction chamber 128B. Since the reactant gas inlet side of tape 114 is not heated, the infiltration rate of reactant gas 114 is low in this region. However, the top side of tape 114 is at a higher temperature and the reaction product in that region forms at a higher rate. As a result, the deposition rate of coating infiltrant in the upper half of the tape balances that forming in the reactant gas feed side and a constant coating deposition rate may be achieved through the thickness of the tape coating any uncoated fiber left after deposition in reaction zone 128A.

Infiltrated coated ceramic fiber tape 114 exits reaction chamber 128A and enters collection chamber 148 through tape inlet seal 146. Collection chamber 148 is maintained under a positive controlled atmosphere by purge gas 124C entering purge gas inlet 122C. Coated ceramic fiber tape 114 passes under tension roller 152 and is wound on collection spool 150 in direction indicated by arrow 115. By passing coated fiber tape 114 under tension roller 152, the deformation imparted to the tape will tend to separate fiber-to-fiber contact points (i.e. "bridges") and increase the flexibility of coated fiber tape 114. Collection spool 150 is driven by a variable speed drive (not shown) to gather completed CMC precursor tape 114 for further processing. Collection chamber 148 is maintained under a positive controlled atmosphere by purge gas 124C entering purge gas inlet 122C.

Fiber interface coating systems of the present disclosure are focused at high temperature ceramic matrix composite (CMC) precursor materials for applications in an oxidizing environment such as a gas turbine or other form of a combustion engine. Primary fibers may include carbon, silicon carbide, boron carbide, aluminum oxide and others known in the art.

Fiber interface coatings are typically duplex coatings consisting of an initial layer deposited directly on the fiber to tailor the adhesive strength of the fiber/matrix interface. Secondary ceramic layers in duplex interface coatings may be oxidation resistant or hydrolysis resistant coatings. Non-limiting examples of fiber interface coating systems include carbon, doped carbon, silicon carbide, silicon nitride, boron nitride, silicon doped boron nitride, boron carbide and others known in the art. Multi-layer interfaced coating systems of the disclosure may include alternating layers of duplex coating systems. Non-limiting examples include (carbon/silicon carbide) x n, (boron nitride/silicon nitride) x n, (boron nitride/silicon carbide) x n, and others known in the art. In these examples n may be up to 5 iterations.

### Discussion of Possible Embodiments

The following are non-exclusive descriptions of possible embodiments of the present invention.

A method to form a ceramic interface coating on ceramic matric composite (CMC) precursor tape by a continuous process may include: passing a ceramic fiber woven cloth tape or unidirectional tape of a first ceramic with a first and second surface through at least one zone of a continuous vacuum chemical vapor deposition (CVD) or chemical vapor infiltration (CVI) reactor heated to a reaction temperature; and directing a flow of CVD or CVI reactant gas of a second ceramic at the first surface of the tape in a direction perpendicular to the tape such that the reactant gas passes through the tape in a forced flow process depositing the second ceramic on the fibers of the first ceramic thereby coating the fibers of the first ceramic tape with the second ceramic interface coating to form a coated fiber CMC precursor tape product.

The method of the preceding paragraph can optionally include, additionally and/or alternatively any, one or more of the following features, configurations and/or additional components:

A temperature of the first surface of the tape may be equal to a temperature of the second surface of the tape.

The temperature of the first surface of the tape may be lower than the temperature of the second surface of the tape.

The reactant gas pressure is higher at the first surface of the tape than at the second surface of the tape.

The method may comprise at least two reaction zones.

The reaction temperature may be from about 575°F (302°C) to about 2730°F (1499°C).

The width of the tape may be from about 6 inches (15.24 cm) to about 60 inches 125.4 cm).

The thickness of the cloth tape or unidirectional tape may be from about 0.006 inches (152 microns) to about 0.25 inches (6352 microns).

The first ceramic may be carbon, silicon carbide, boron carbide or aluminum oxide.

The second ceramic may be carbon, doped carbon, silicon carbide, silicon nitride, boron nitride, silicon doped boron nitride or boron carbide.

An apparatus to continuously form ceramic interface coatings on ceramic matrix composite (CMC) precursor tape may include: a ceramic fiber woven cloth tape or unidirectional tape of a first ceramic with a first and second surface mounted on a supply spool in a storage chamber; a tension roller and a purge gas inlet in the storage chamber; a storage chamber tape outlet seal; at least one chemical vapor deposition (CVD) or chemical vapor infiltration (CVI) deposition zone comprising; a vacuum chamber; a tape inlet seal; a reactive gas dispensing system directed at the first side of the tape in a direction perpendicular to the tape for forming a CVD or CVI coating of a second ceramic on the fibers to form an interface coating; a purge gas inlet; at least one heating element for heating the tape to a CVD or CVI reaction temperature; a vacuum system; high temperature insulation; and a tape outlet seal; a tape collection spool mounted on a drive shaft in a collection chamber; a tension roller, a purge gas inlet and tape inlet seal in the collection chamber; and a variable speed drive attached to the collection spool to gather the coated CMC precursor tape product on the collection spool.

The apparatus of the preceding paragraph can optionally include, additionally and/or alternatively any, one or more of the following features, configurations and/or additional components:

The heating elements provide a temperature of the second side of the tape equal to a temperature of the first side of the tape.

The temperature of the second side of the tape may be lower than the temperature of the first side.

The reactive gas pressure at the first side of the tape may be higher than at the second side of the tape.

The heating elements may be resistance heated graphite rods or plates positioned on one or both sides of the tape.

The reaction temperature may be from about 575°F (302°C) to about 2730°F (1499°C).

The apparatus may comprise at least two deposition zones.

The first ceramic may be carbon, silicon carbide, boron carbide, or aluminum oxide.

The second ceramic may be carbon, doped carbon, silicon carbide, silicon nitride, boron nitride, silicon doped boron nitride, or boron carbide.

The width of the tape may be from about 6 inches (15.24 cm) to about 60 inches (125.4 cm).

While the invention has been described with reference to an exemplary embodiment(s), it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment(s) disclosed, but that the invention will include all embodiments falling within the scope of the appended claims.

## Claims

1. A method to form a ceramic interface coating on ceramic matrix composite (CMC) precursor tape by a continuous process comprising:
passing a tape (14), comprising a ceramic fiber woven cloth tape or unidirectional tape, of a first ceramic with a first and second surface through at least one reaction zone of a continuous vacuum chemical vapor deposition (CVD) or chemical vapor infiltration (CVI) reactor heated to a reaction temperature; and
directing a flow of CVD or CVI reactant gas of a second ceramic at the first surface of the tape in a direction perpendicular to the tape such that the reactant gas passes through the tape in a forced flow process depositing the second ceramic on the fibers of the first ceramic thereby coating the fibers of the first ceramic tape with the second ceramic interface coating to form a coated fiber CMC precursor tape product.

2. The method of claim 1 wherein a temperature of the first surface of the tape is equal to a temperature of the second surface of the tape, and preferably wherein the temperature of the first surface of the tape is lower than the temperature of the second surface of the tape.

3. The method of claims 1 or 2 wherein a reactant gas pressure is higher at the first surface of the tape than at the second surface of the tape.

4. The method of any preceding claim wherein the method comprises at least two reaction zones.

5. The method of any preceding claim wherein the reaction temperature is from about 575°F (302°C) to about 2730°F (1499°C).

6. The method of any preceding claim wherein the width of the tape (14) is from about 6 inches (15.24 cm) to about 60 inches (125.4 cm), and preferably wherein the thickness of the cloth sheet is from about 0.006 inches (152 microns) to about 0.25 inches (6352 microns).

7. The method of any preceding claim wherein the first ceramic comprises carbon, silicon carbide, boron carbide or aluminum oxide, and preferably wherein the second ceramic comprises carbon, doped carbon, silicon carbide, silicon nitride, boron nitride, silicon doped boron nitride, or boron carbide.

8. An apparatus to continuously form ceramic interface coatings on ceramic matrix composite (CMC) precursor tape comprising:
a tape (14), comprising a ceramic fiber woven cloth tape or unidirectional tape, of a first ceramic with a first and second surface mounted on a supply spool in a storage chamber (12);
a tension roller (18) and a purge gas inlet (22) in the storage chamber (12);
a storage chamber tape outlet seal (26);
at least one chemical vapor deposition (CVD) or chemical vapor infiltration (CVI) reaction zone comprising;
a vacuum chamber;
a tape inlet seal (46);
a reactant gas dispensing system directed at the first side of the tape in a direction perpendicular to the tape for forming a CVD or CVI coating of a second ceramic on the fibers to form an interface coating;
a purge gas inlet;
at least one heating element for heating the tape (14) to a CVD or CVI reaction temperature;
a vacuum system;
high temperature insulation; and
a tape outlet seal;
a tape collection spool (50) mounted on a drive shaft in a collection chamber (48);
a tension roller, a purge gas inlet and a tape inlet seal in the collection chamber (48); and
a variable speed drive attached to the collection spool (50) to gather the coated CMC precursor tape product on the collection spool (50).

9. The apparatus of claim 8 wherein heating elements provide a temperature of the second side of the tape equal to a temperature of the first side, and preferably wherein the temperature of the first side of the tape is lower than the temperature of the second side of the tape.

10. The apparatus of claims 8 or 9 wherein the reactant gas pressure at the first side of the tape is higher than at the second side of the tape.

11. The apparatus of claim 9 wherein the heating elements are resistance heated graphite rods or plates positioned on one or both sides of the tape.

12. The apparatus of claims 8-11 wherein the reaction temperature is from about 575°F (302°C) to about 2730°F (1499°C).

13. The apparatus of claims 8-12 wherein the apparatus comprises at least two reaction zones.

14. The apparatus of claims 8-12 wherein the first ceramic comprises carbon, silicon carbide, boron carbide or aluminum oxide, and preferably wherein the second ceramic comprises carbon, doped carbon, silicon carbide, silicon nitride, boron nitride, silicon doped boron nitride, or boron carbide.

15. The method of claims 8-14 wherein the width of the tape (14) is from about 6 inches (15.24 cm) to about 60 inches (125.4 cm).
